# EUROPEAN PATENT APPLICATION

(11) **EP 4 513 372 A1**
(43) Date of publication of application: **26.02.2025**
(21) Application number: 24183201.3
(22) Date of filing: 19.06.2024
(51) Int. Cl.: G06F 30/15, G06F 30/17, G06F 30/23

(54) **MODELING JOINTS WITH FASTENERS**

(30) Priority: 24.08.2023 US 202318454961
(71) Applicant: The Boeing Company, Arlington, VA 22202 (US)
(72) Inventor: LIN, Zhong, 22202 Arlington (US); MUNJAL, Vikas, 22202 Arlington (US); WANTHAL, Steven Paul, 22202 Arlington (US)
(74) Representative: Bryn-Jacobsen, Caelia

(57) **Abstract**

A method for modeling joints with fasteners includes receiving multiple input parameters of multiple components connectable with one or more fasteners; calculating multiple second level parameters with a computer based on the input parameters; building multiple component models of the components absent the one or more fasteners based on the second level parameters; subtracting multiple bolt bores from the component models; and generating an assembly model by combining the component models with one or more fastener models of the one or more fasteners in the bolt bores. The method further includes applying multiple boundary conditions to the assembly model; applying multiple loads to the assembly model under the boundary conditions to generate multiple analysis key words; and generating an input file based on the analysis key words. The input file is suitable for a finite element analysis.

## Description

### TECHNICAL FIELD

The disclosure relates generally to modeling components, and in particular, to modeling joints with fasteners.

### BACKGROUND

Unaccounted local stresses and strains are a leading cause of cracking discovered during a full-scale fatigue test. Changing designs and tooling to fix the problems during the certification process is costly and causes program delays. Existing modeling solutions are either manual or of sufficiently low fidelity in terms of an ability to capture three-dimensional contact interactions between fasteners and structure details. Manual model building processes also prevent timely assessment of a full range of manufacturing variations.

Accordingly, those skilled in the art continue with research and development efforts in the field of modeling joints of two or more components with one or more fasteners to improve stress predictions at fastener locations to mitigate risk and do so within program schedules.

### SUMMARY

A method for modeling joints with fasteners is provided herein. The method includes receiving a plurality of input parameters of a plurality of components connectable with one or more fasteners; calculating a plurality of second level parameters with a computer based on the plurality of input parameters; building a plurality of component models of the plurality of components absent the one or more fasteners based on the plurality of second level parameters; subtracting a plurality of fastener bores from the plurality of component models; generating an assembly model by combining the plurality of component models with one or more fastener models of the one or more fasteners in the plurality of fastener bores; applying a plurality of boundary conditions to the assembly model; applying a plurality of loads to the assembly model under the plurality of boundary conditions to generate a plurality of analysis key words; and generating an input file based on the plurality of analysis key words. The input file is suitable for a finite element analysis.

In one or more examples, the method further includes rotating a plurality of component nodes of the plurality of component models to align with a fiber orientation of the plurality of components.

In one or more examples, the method further includes calculating a center of a curvature of the assembly model.

In one or more examples, the method further includes updating a plurality of component nodes of the plurality of component models based on the center and the curvature of the assembly model.

In one or more examples, the method further includes assigning a material to the plurality of component models.

In one or more examples, the method further includes adding one or more extra models to the assembly model. The one or more extra models include one or more strap models, spacer models, shim models, or a combination thereof.

In one or more examples, the method further includes translating the one or more extra models within the assembly model.

In one or more examples, the method further includes rotating the one or more extra models within the assembly model.

In one or more examples, the method further includes reading the plurality of input parameters and the one or more fasteners from one or more libraries.

A system for modeling joints with fasteners is provided herein. The system includes one or more libraries operational to store a plurality of input parameters of a plurality of components and a plurality of fasteners and a computer. The computer is operational to receive the plurality of input parameters of the plurality of components connectable with one or more fasteners from the one or more libraries; calculate a plurality of second level parameters based on the plurality of input parameters; build a plurality of component models of the plurality of components absent the one or more fasteners based on the plurality of second level parameters; subtract a plurality of fastener bores from the plurality of component models; generate an assembly model by combining the plurality of component models with one or more fastener models of the one or more fasteners in the plurality of fastener bores; apply a plurality of boundary conditions to the assembly model; apply a plurality of loads to the assembly model under the plurality of boundary conditions to generate a plurality of analysis key words; and generate an input file based on the plurality of analysis key words. The input file is suitable for a finite element analysis.

In one or more examples of the system, the computer is further operational to rotate a plurality of component nodes of the plurality of component models to align with a fiber orientation of the plurality of components.

In one or more examples of the system, the computer is further operational to calculate a center of a curvature of the assembly model.

In one or more examples of the system, the computer is further operational to update a plurality of component nodes of the plurality of component models based on the center and the curvature of the assembly model.

In one or more examples of the system, the computer is further operational to assign a material to the plurality of component models.

In one or more examples of the system, the computer is further operational to add one or more extra models to the assembly model. The one or more extra models include one or more strap models, spacer models, shim models, or a combination thereof.

In one or more examples of the system, the computer is further operational to translate the one or more extra models within the assembly model.

In one or more examples of the system, the computer is further operational to rotate the one or more extra models within the assembly model.

A non-transitory computer readable storage medium storing instructions that control data processing is provided herein. The instructions, when executed by a processor cause the processor to perform a plurality of operations including receiving a plurality of input parameters of a plurality of components connectable with one or more fasteners; calculating a plurality of second level parameters based on the plurality of input parameters; building a plurality of component models of the plurality of components absent the one or more fasteners based on the plurality of second level parameters; subtracting a plurality of fastener bores from the plurality of component models; generating an assembly model by combining the plurality of component models with one or more fastener models of the one or more fasteners in the plurality of fastener bores; applying a plurality of boundary conditions to the assembly model; applying a plurality of loads to the assembly model under the plurality of boundary conditions to generate a plurality of analysis key words; and generating an input file based on the plurality of analysis key words. The input file is suitable for a finite element analysis.

In one or more examples of the non-transitory computer readable storage medium, the plurality of operations further includes rotating a plurality of component nodes of the plurality of component models to align with a fiber orientation of the plurality of components.

In one or more examples of the non-transitory computer readable storage medium, the plurality of operations further includes calculating a center of a curvature of the assembly model; and updating a plurality of component nodes of the plurality of component models based on the center and the curvature of the assembly model.

The above features and advantages, and other features and advantages of the present disclosure are readily apparent from the following detailed description of the best modes for carrying out the disclosure when taken in connection with the accompanying drawings.

### BRIEF DESCRIPTION OF THE DRAWINGS

FIGS. 1A to 1B are a flow diagram of a method of operation of plug-in modeling code in accordance with one or more exemplary examples.
FIG. 2 is a detailed flow diagram of calculating second level parameters in accordance with one or more exemplary examples.
FIG. 3 is a detailed flow diagram of building components in accordance with one or more exemplary examples.
FIG. 4 is a detailed flow diagram of updating nodes for a fiber aligned mesh in accordance with one or more exemplary examples.
FIG. 5 is a detailed flow diagram for curvature in accordance with one or more exemplary examples.
FIG. 6 is a detailed flow diagram of assembling components in accordance with one or more exemplary examples.
FIG. 7 is a detailed flow diagram obtaining fastener parameters in accordance with one or more exemplary examples.
FIG. 8 is a detailed flow diagram for obtaining material parameters in accordance with one or more exemplary examples.
FIG. 9 is schematic block diagram of a computer-based system in accordance with one or more exemplary examples.
FIG. 10 is a schematic plan and cross-sectional view diagram of a joint 340 in accordance with one or more exemplary examples.

### DETAILED DESCRIPTION

Various examples of the disclosure provide a method and/or a system for modeling joints with fasteners. The method includes receiving input parameters of components connectable with one or more fasteners, calculating second level parameters based on the input parameters, and building component models of the components absent the fasteners based on the second level parameters. The method further includes subtracting bolt bores from the component models, generating an assembly model by combining the component models with fastener models of the fasteners in the bolt bores, and applying boundary conditions to the assembly model. The method also includes applying loads to the assembly model, and generating an input file suitable for a finite element analysis based on the responses of the assembly model to the loads and the boundary conditions.

In some examples, method may include rotating component nodes of the component models to align with a fiber orientation of the components, calculating a center of a curvature of the assembly model, and updating the component nodes of the component models based on the center and the curvature of the assembly model. Where specified for a design of the joint, the method may include adding one or more extra models to the assembly model. The extra models generally include one or more strap models, spacer models, shim models, or a combination thereof. The extra models may be translated and/or rotated within the assembly model. The system generally includes a computer, and one or more libraries. The libraries store input parameters of components and fasteners. The computer is operational to receive the input parameters of the components connectable with one or more fasteners from the libraries, calculate second level parameters based on the input parameters, and build component models of the components absent the fasteners based on the second level parameters. The computer may also subtract bolt bores from the component models, generate an assembly model by combining the component models with fastener models of the fasteners in the fastener bores (or holes), apply boundary conditions to the assembly model, and apply loads to the assembly model. The computer also generates an input file suitable for a finite element analysis based on responses of assembly model to the loads and the boundary conditions. The system automates high-fidelity physics-based three-dimensional finite element analysis models and has been shown to provide accurate stresses and be able to access effect of manufacturing variation to further reduce risk.

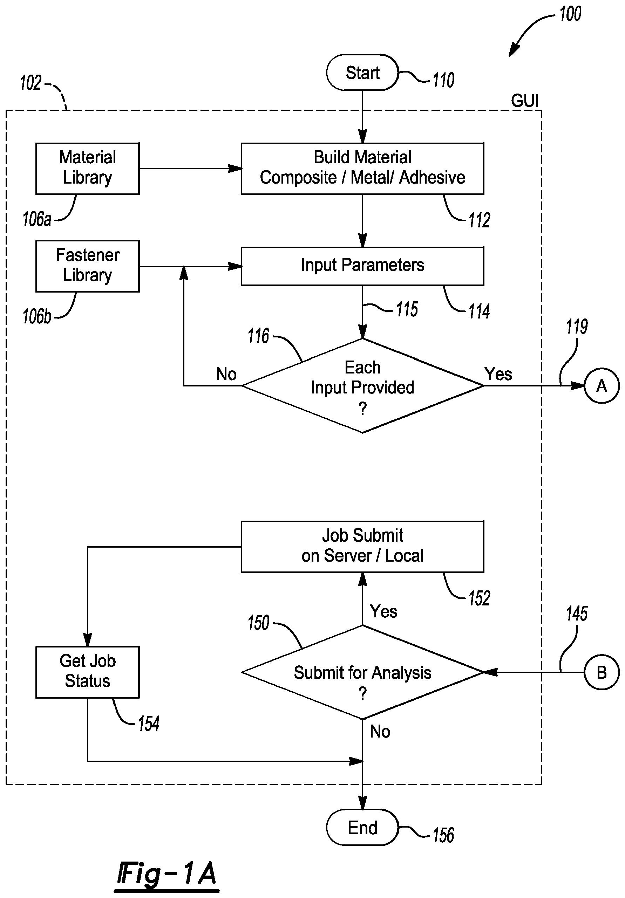

Referring to FIGS. 1A to 1B, a flow diagram of an example method of operation of modeling plug-in code is shown in accordance with one or more exemplary examples. The method (or process) 100 may be implemented by one or more computers and one or more user interface devices (e.g., a monitor with a keyboard and/or mouse). The method 100 generally includes steps 102 to 156, as illustrated. The sequence of steps is shown as a representative example. Other step orders may be implemented to meet the criteria of a particular application.

In various examples, the functionality provided by the method 100 is divided between graphical user interface (GUI) functions 102 and kernel functions 104. The GUI functions 102 include access to a material library 106a, access to a fastener library 106b, a start step 110, a build material/reading step 112, an input parameter selection step 114, an input decision block 116, a submit for analysis decision block 150, a job submit step 152, a get job status step 154, and an end step 156.

The kernel functions 104 include a calculate second level parameters step 120 and a loop step 122. The loop step 122 includes a build component step 124, a fiber orientated decision block 126, an update node for fiber aligned mesh step 128, a curved decision block 130, a curvature updating step 132, and an assign material step 134. The kernel function 104 further includes an assemble coupons step 136, an apply boundary conditions step 138, an apply loads step 140, a write first input file step 142, a solver decision block 144, a convert format step 146, and a write second input file step 148. The calculate second level parameters step 120 receives the input parameters 115 from the input decision block 116 in the receiving step 119. The solver decision block 144 and the write second input file step 148 presented an input file 145 to the submit for analysis decision block 150.

The GUI functions 102 implement user input selection functions and job status functions. The GUI functions 102 are operational to provide a mechanism for a user to select the various (e.g., N) components used to model joints as well as a number, type and placement of fasteners used to hold the joints together. The GUI functions 102 are also operational to provide the user with a mechanism to determine which jobs are to be submitted for analysis and the status of such jobs running either on one or more remove server computers and/or one or more local server computers.

The kernel functions 104 implement modeling tools used to generate one of two types of input files that model the joints. In various examples, a first type of input file may be an Abaqus/CAE (Complete Abaqus Environment) input file. Abaqus/CAE is a software application used for both the modeling and analysis of mechanical components and assemblies (preprocessing) and visualizing the finite element analysis result. Abaqus/CAE was developed by and is available from Dassault Systems, Velizy-Villacoublay, France. In some examples, the second type of input file may be a LS-Dyna format input file. LS-Dyna is a general-purpose multi-physics simulation software package. LS-Dyna was developed by and is available from Ansys, Canonsburg, Pennsylvania. In various examples, the input files may present the model as a finite element mode. In some examples, the input files may present the model as a geometrical model.

The material library 106a implements a database of materials suitable for use in fabricating the joints. Material data in the material library 106a may include, but is not limited to, common homogeneous isotropic materials (e.g., metals) and custom user materials, composite ply elastic and progressive failure parameters, material models for progressive failure analysis (e.g., Hashin, Helius, and expandable to others), and adhesive materials. Other types of material parameters may be included to meet the design criteria of a particular application.

The fastener library 106b implements a database of fasteners suitable for use in fabricating the joints. Fastener data in the fastener library 106b may include, but is not limited to, protruding head and counter-sink fasteners, bolts and nuts. Other types of fastener parameters may be included to meet the design criteria of a particular application.

In the step 110, the method 100 begins by gathering (or reading) the build material in the step 112 based on a joint design provided by a user. The build material/reading step 112 is operational to assemble the materials used to model the joint based on user supplied design. The build material/reading step 112 establishes the parts, material types, spacers, thicknesses, lengths, widths, fasteners, number and placement of holes, patterns, and boundaries for the joint model. Fastener parameters from the fastener library 106b are added to the build material parameters in the input parameter selection step 114. The input parameter selection step 114 is operational to buffer the material parameters and fastener parameters as selected by the user.

A check is subsequently performed at the input decision block 116. If insufficient parameters are buffered in the input parameter selection step 114, the method 100 returns to the input parameter selection step 114 to gather the missing parameters. Once the appropriate parameters are present, the method continues to the kernel functions 104 (e.g., the calculate second level parameters step 120) where the input parameters 115 are received by the calculate second level parameters step 120 through the Yes branch of the input decision block 116.

The calculate second level parameters step 120 is operational to generate second level parameters 121 from the input parameters received from the GUI functions 102. The step 122 loops around the build component step 124 to the assign material step 134 for the various components in the design configuration of the joint being modeled. The build component step 124 generates an initial version of the component models 125a (e.g., coupon models 125b, fastener models 125c, extra models 125d, strap models 125e, spacer models 125f, and shim models 125g) based on the input parameter selection step 114 and the second level parameters 121. A check is made in the fiber orientation decision block 126 to determine if the component includes a mesh with a specific fiber orientation. If the specific orientation is detected, the nodes of the component are updated for a fiber alignment to the mesh in the step 128. Thereafter, or if the specific orientation was not detected, another check is performed in the curved decision block 130 for a curvature of the component. If a curvature is detected, the loop step 122 continues with the curvature updating step 132. In the curvature updating step 132, the nodes of the model 125a-125g are updated to account for the curvature. After the nodes have been updated for the curvature, or if no curvature was detected, materials for the component are assigned in the assign material step 134. The loop step 122 loops around to the build component step 124 for each component in the joint. Once finished, the method 100 continues with the assemble coupons step 136.

In the assemble coupons step 136, the component models 125a-125g, as built and possibly updated, are assembled into coupons to form an assembly model 125h of the joint. Boundary conditions 139 are applied to the assembly model 125h in the apply boundary conditions step 138. In the apply loads step 140, one or more loads 141 are applied to the assembly model 125h under the boundary conditions 139 to produce analysis key words 143. The analysis key words 143 may be captured in a first input file format (e.g., an Abaqus/CAE format). The results data is written into (or generate) an input file 145 by the write first input file step 142. A check is performed in the solver decision block 144 to determine if the format of the input file 145 written/generated in the write first input file step 142 may be converted into another input file format. If the format of the input file 145 is to be converted, the input file 145 is converted from the first input file format to a second input file format (e.g., the LS-Dyna format) by the convert format step 146. Thereafter, the data in the second input file format is written into (or generated) an input file 145 (e.g., with the LS-Dyna input file format) in the write second input file step 148.

The input file 145 in the first input file format (e.g., written in the write first input file step 142 and determined not to be converted in the solver decision block 144) or the input file 145 in the second input file format (e.g., written in the step 148) is presented to the submit for analysis decision block 150. In the submit for analysis decision block 150, if the input file is to be submitted for analysis (e.g., by the physics-based three-dimensional finite element analysis), the input file is submitted to one or more computer executing the Abaqus/CAE or the LS-Dyna simulation software in the submit step 152. During the simulation, the get job status step 154 may provide feedback to the user regarding the ongoing results of the simulation. After the simulation is complete, or no simulation was started per the submit for analysis decision block 150, the method 100 terminates in the end step 156.

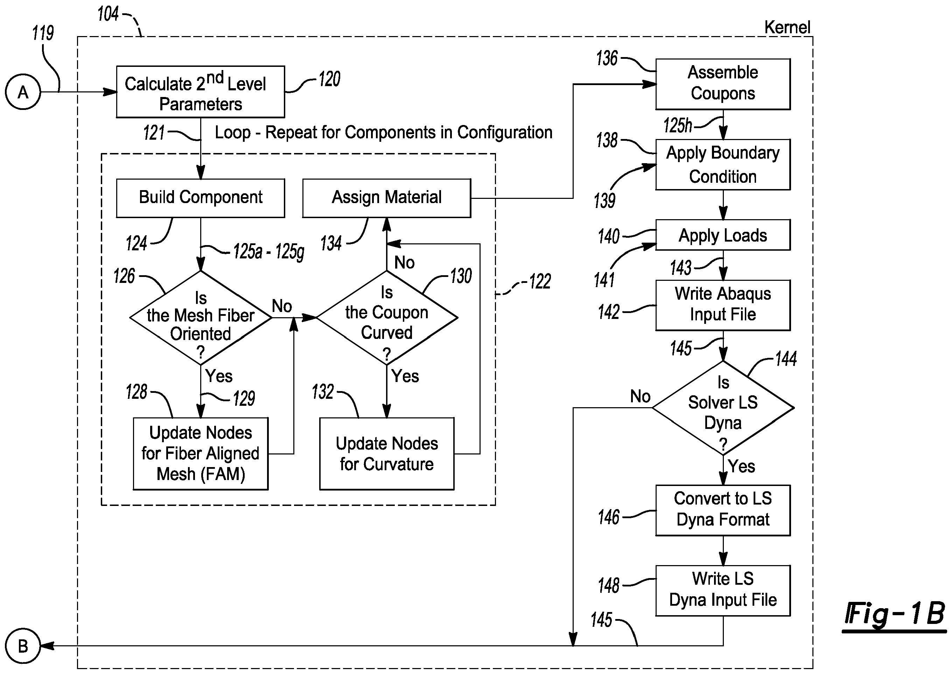

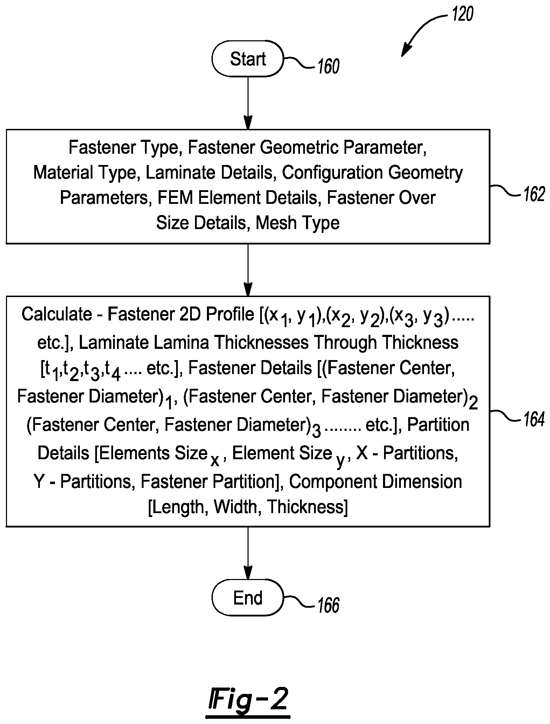

Referring to FIG. 2 with reference back to FIGS. 1A and 1B, a detailed flow diagram of an example implementation of the calculate second level parameters step 120 is shown in accordance with one or more exemplary examples. The calculate second level parameters step 120 generally includes steps 160 to 166, as illustrated. The sequence of steps is shown as a representative example. Other step orders may be implemented to meet the criteria of a particular application.

In the step 160, the calculations of the second level parameters may start. In the step 162, requested details are received from the user about joint parameters of the joint being modeled. The requested joint parameters may include, but are not limited to, fastener types, fastener geometric parameters, material types, laminate details, configuration geometry parameters, finite element method (FEM) element details, fastener over size details, and mesh types. Other joint parameters may be considered to meet the design criteria of a particular application. Using the input parameters 115 provided by the input decision block 116, the second level parameters are calculated in the step 164. The calculations may include, but are not limited to:
Calculate - fastener two-dimensional profile [(x₁, y₁), (x₂, y₂), (x₃, y₃) ..... etc.];
Calculate - laminate lamina thicknesses;
Calculate -through thickness [t₁, t₂, t₃, t₄ .... etc.];
Calculate - fastener details [e.g., (Fastener Center, Fastener Diameter)i, (Fastener Center, Fastener Diameter)₂, (Fastener Center, Fastener Diameter)₃ ........ etc.];
Calculate - partition details [elements sizeₓ, element size_{y} , X-partitions, Y-partitions, fastener partition]; and
Calculate - component dimension [length, width, thickness].

The calculations of the second level parameters end in the step 166.

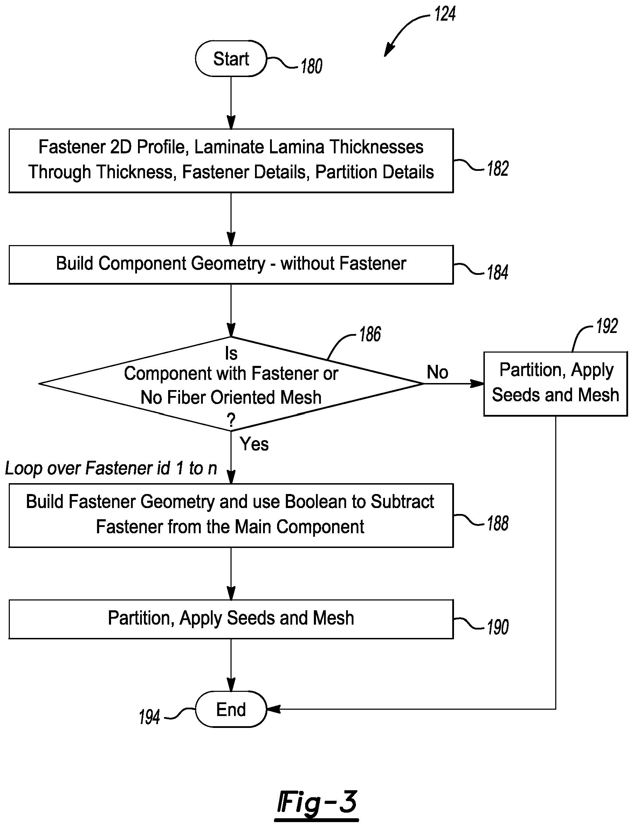

Referring to FIG. 3 with references back to FIGS. 1A and 1B, a detailed flow diagram of an example implementation of the build component step 124 is shown in accordance with one or more exemplary examples. The build component step 124 generally includes steps 180 to 194, as illustrated. The sequence of steps is shown as a representative example. Other step orders may be implemented to meet the criteria of a particular application.

In the step 180, the building of the components operations starts. Component parameters from the user are received in the step 182 to further defined the components that make up the joint being modeled. The component parameters may include, but are not limited to, fastener two-dimensional profiles, laminate lamina thicknesses, through thickness, fastener details, and partition details. Other component parameters may be accounted for to meet the design criteria of a particular application.

In the step 184, the components geometries are built without the fasteners. A check is performed in the step 186 to determine if the component has fasteners or lacks a fiber-orientated mesh. If fasteners and/or no fiber-oriented mesh is detected, for each component in the joint (e.g., components 1 to N), the build component step 124 builds the fastener geometry and use Boolean logic partitioning to subtract the fasteners from the main component in the subtracting step 188, and subsequently partitions, and applies seeds and the mesh in the step 190. If the component is without fasteners or has a fiber-oriented mesh, the step 192 partitions and applies seeds and the mesh. Upon completion of the step 190 or the step 192, the building of the components ends in the step 194.

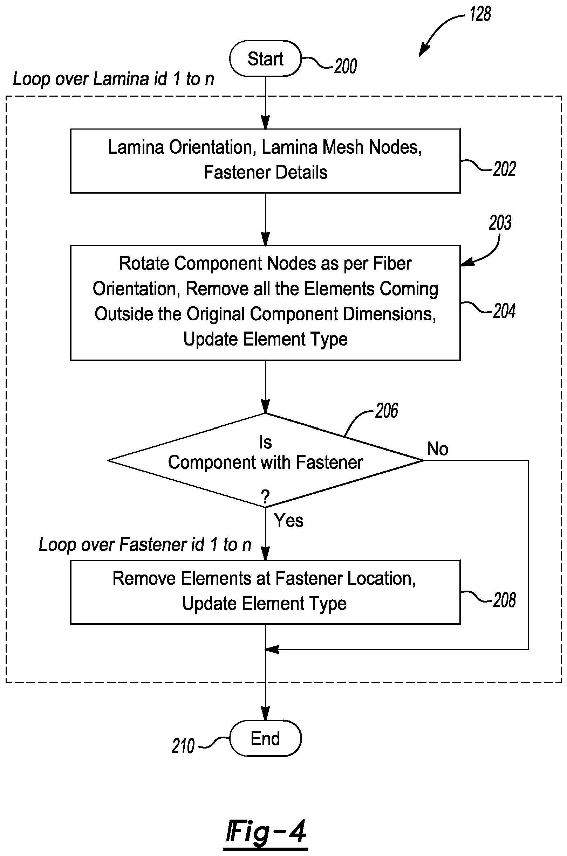

Referring to FIG. 4 with references back to FIGS. 1A and 1B, a detailed flow diagram of an example implementation of the update nodes for fiber aligned mesh step 128 is shown in accordance with one or more exemplary examples. The fiber aligned mesh step 128 generally includes steps 200 to 210, as illustrated. The sequence of steps is shown as a representative example. Other step orders may be implemented to meet the criteria of a particular application.

The updating of the nodes for the fiber alignment of the mesh begins in the step 200. In the step 202, mesh parameters from the user are received for the component. The mesh parameters may include, but are not limited to, lamina orientations, lamina mesh nodes, and fastener details. Other mesh parameters may be implemented to meet the design criteria of a particular application.

In the rotating step 204, the component nodes 129 are rotated as per the fiber orientation 203, elements coming outside the original component dimensions are removed, and element types are updated as appropriate. A check is performed in the decision block 206 to determine if the component includes fasteners. If fasteners are associated with the component (e.g., there are bores specified for fasteners), elements at fastener locations are removed, and the element type is updated as appropriate. After the elements at the fastener locations have been removed in the step 208, or no fasteners were detected in the decision block 206, the node updating for the fiber alignment ends in the step 210.

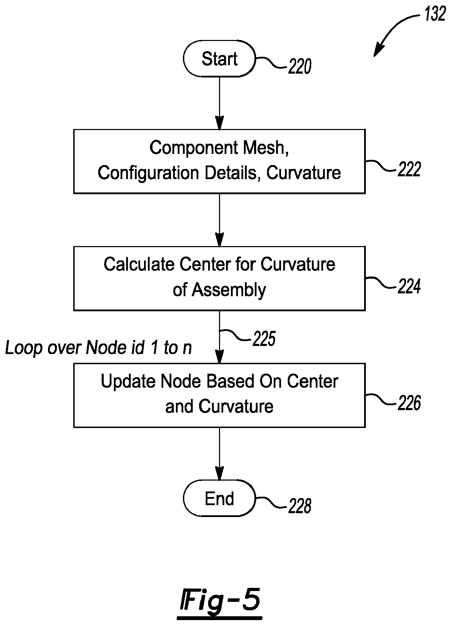

Referring to FIG. 5 with references back to FIGS. 1A and 1B, a detailed flow diagram of an example implementation of the curvature updating step 132 is shown in accordance with one or more exemplary examples. The curvature updating step 132 generally includes steps 220 to 228, as illustrated. The sequence of steps is shown as a representative example. Other step orders may be implemented to meet the criteria of a particular application.

The updating of the node for a curvature begins in the step 220. In the step 222, curvature parameters from the user are received for the component. The curvature parameters may include, but are not limited to, component mesh details, configuration details, and the curvature details. Other curvature parameters may be implemented to meet the design criteria of a particular application.

Calculations to determine a center of curvature 225 of the joint (or assembly) are performed in the calculating step 224. The update step 226 is loop 1 to N time, once for each of the N components. In the update step 226, nodes of a component are updated based on the center of curvature 225 and the actual curvature. Updating the nodes for the curvature ends in the step 228.

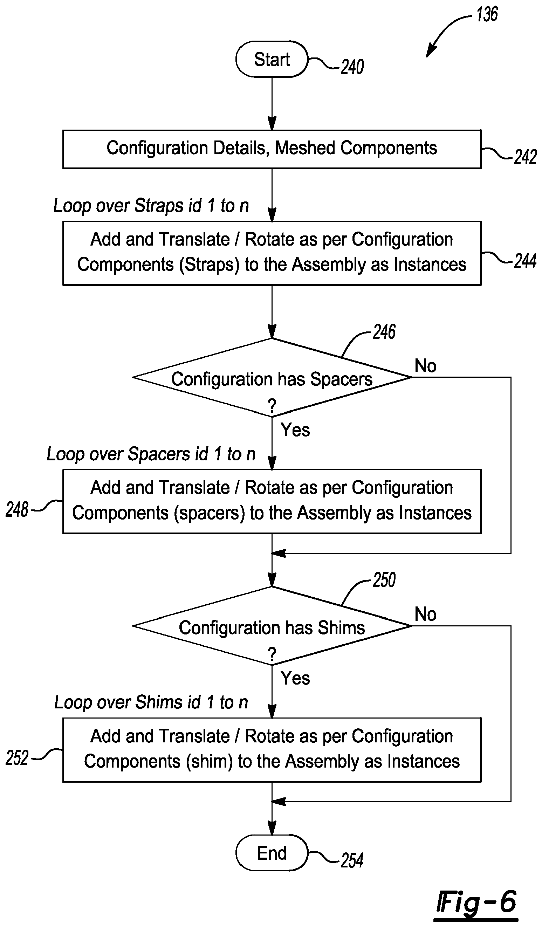

Referring to FIG. 6 with references back to FIGS. 1A and 1B, a detailed flow diagram of an example implementation of the assemble coupons step 136 is shown in accordance with one or more exemplary examples. The assemble coupons step 136 generally includes steps 240 to 254, as illustrated. The sequence of steps is shown as a representative example. Other step orders may be implemented to meet the criteria of a particular application.

The assembling of the components begins in the step 240. In the step 242, configuration parameters from the user are received for the component. The configuration parameters may include, but are not limited to, configuration details and meshed component details. Other configuration parameters may be implemented to meet the design criteria of a particular application.

The step 244 is looped, once for each of the N straps type components. In the step 244, a strap is added and translated/rotated, as per the configuration details for the straps, to the joint as instances. A check is performed in the step 246 to determine if the joint include spacers. If spacers are detected, the spacers are added and translated/rotated, as per the configuration details for the spaces, to the joint as instances in the step 248. After the spacers have been added in the step 248, or no spacers were detected in the decision block 246, a check is performed in the decision block 250 to determine if the joint include shims. If shims are detected, the shims are added and translated/rotated, as per the configuration details for the shims, to the joint as instances in the step 252. After the shims have been added in the step 252, or no spacers were detected in the decision block 250, the assembling ends in the step 254.

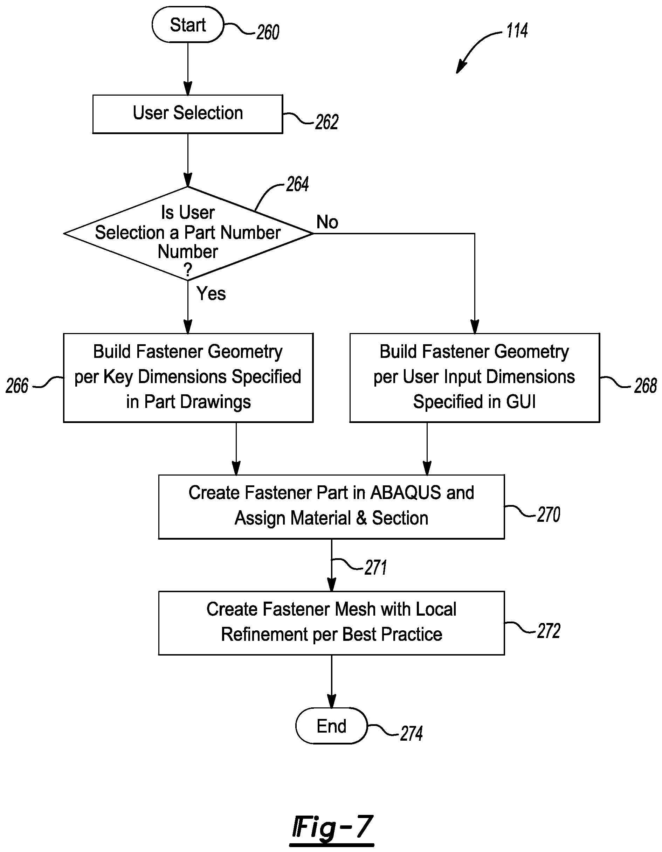

Referring to FIG. 7 with references back to FIGS. 1A and 1B, a detailed flow diagram of an example implementation of the input parameter selection step 114 for obtaining fastener parameters is shown in accordance with one or more exemplary examples. The step 114 generally includes steps 260 to 274, as illustrated. The sequence of steps is shown as a representative example. Other step orders may be implemented to meet the criteria of a particular application.

The obtaining of the fastener parameters begins in the step 260. In the step 262, fastener selections are received from the user. The fastener selections may include, but are not limited to, part numbers and fastener geometries specified through the graphical user interface functions 102. Other types of faster selections may be implemented to meet the design criteria of a particular application.

In the decision block 264, the user input is examined to determine if the fastener selection is for a part number or not. If the user input is a part number, fastener geometry is built in the step 266 per dimensions specified in the part drawings in the fastener library 106b. If the user input is not a part number, the fastener geometry is built in the step 268 per user input dimensions specified in the GUI 102.

In the assigning step 270, a fastener part is created in ABAQUS and assigned the identified materials 271 and sections. A fastener mesh with local refinement is created in the step 272. In various examples, the fastener mesh creation may be in compliance with best practices. Other types of fastener mesh creation may be implemented to meet the design criteria of a particular application. The fastener selection ends in the step 274.

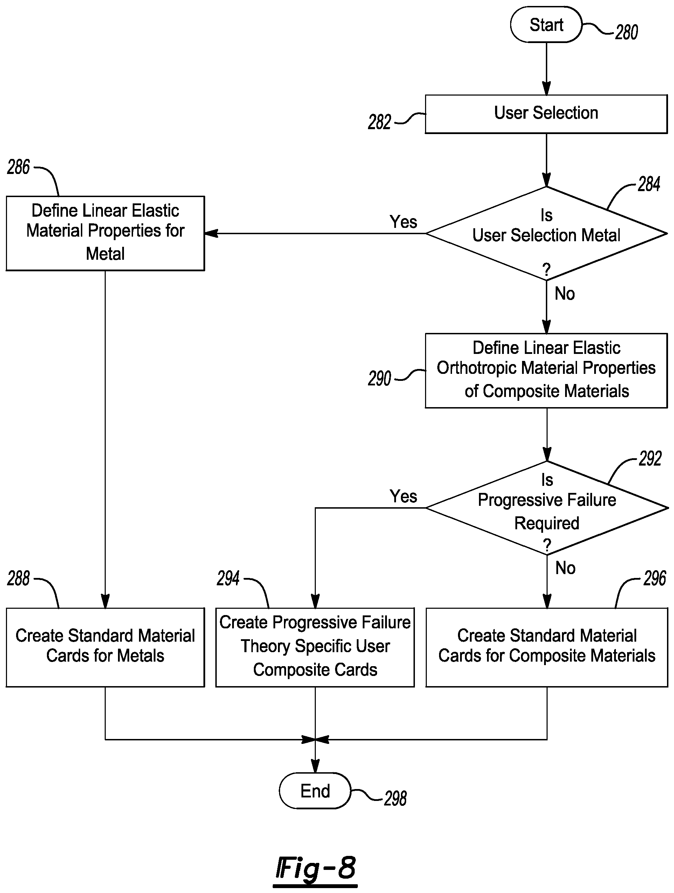

Referring to FIG. 8 with references back to FIGS. 1A and 1B, a detailed flow diagram of an example implementation of the input parameter selection step 114 for obtaining material parameters is shown in accordance with one or more exemplary examples. The step 114 generally includes steps 280 to 298, as illustrated. The sequence of steps is shown as a representative example. Other step orders may be implemented to meet the criteria of a particular application.

The obtaining of the material parameters begins in the step 280. In the step 282, material selections are received from the user. The material selections may include, but are not limited to, metal selections and composite selection. Other material selections may be implemented to meet the design criteria of a particular application.

In the decision block 284, the user input is examined to determine if metals or composites are being used in modeling the component. If metals are being modeled, linear elastic material properties are defined for the metals in the step 286. Next, standard material cards are created for metals in the step 288. If composites are being modeled, linear elastic orthotropic material properties of composite materials are defined in the step 290. A check is performed in the decision block 292 to determine if a progressive failure analysis is appropriate for the composite materials. If the progressive failure analysis is appropriate, a progressive failure theory card specific to the user-defined composite material is created in the step 294. If no progressive failure analysis is appropriate, standard material cards for the composite materials are created in the step 296. The material selection ends in the step 298.

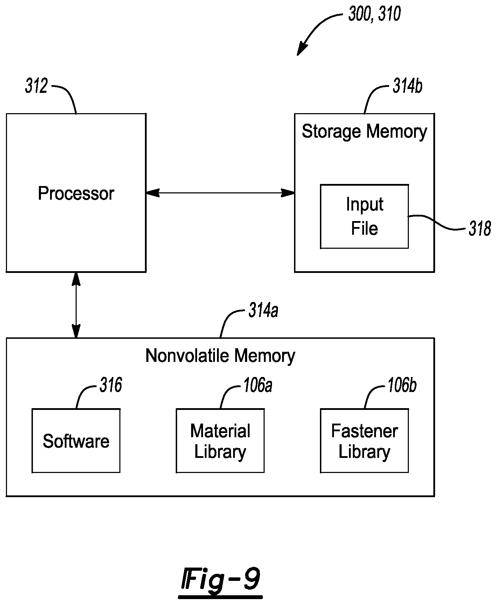

Referring to FIG. 9 with references back to FIGS. 1A and 1B, schematic block diagram of an example implementation of a computer-based system 300 is shown in accordance with one or more exemplary examples. The system 300 is operational to performed the method 100 for modeling joints. The system 300 is operational to generate input files in a non-transitory computer readable storage that are suitable for the finite element analysis (FEA) simulations. The input file defines the joint in software and may be exercised by a FEA simulator to verify proper functionality and performance of the design.

The system 300 includes a computer 310 having one or more processor 312 (one shown) and one or more storage media 314a-314b. A first storage medium (e.g., 314a) may contain one or more instructions 316 (or code or software programs) readable and executable by the processor 312. In various examples, the instructions 316 form a suite of Python scripts. The first storage medium 314a may also record the material library 106a and the fastener library 106b. A storage input file 318 that stores the data of the input file 145 defining the model of the joint may reside in a second storage medium (e.g., 314b). The first storage medium 314a may be a non-transitory computer readable storage medium. The second storage medium 314b may be a non-transitory and/or transitory computer readable storage medium.

The instructions 316 may be read and executed by the computer 310 (e.g., the processor 312) to implement the process of generating the storage input file 318 for the models 125a-125g of the joint. The material library 106a and the fastener library 106b may be accessed as appropriate during execution. In various examples, the instructions 316, the material library 106a, the fastener library 106b, and/or the storage input file 318 may be stored in the same storage medium 314a or 314b.

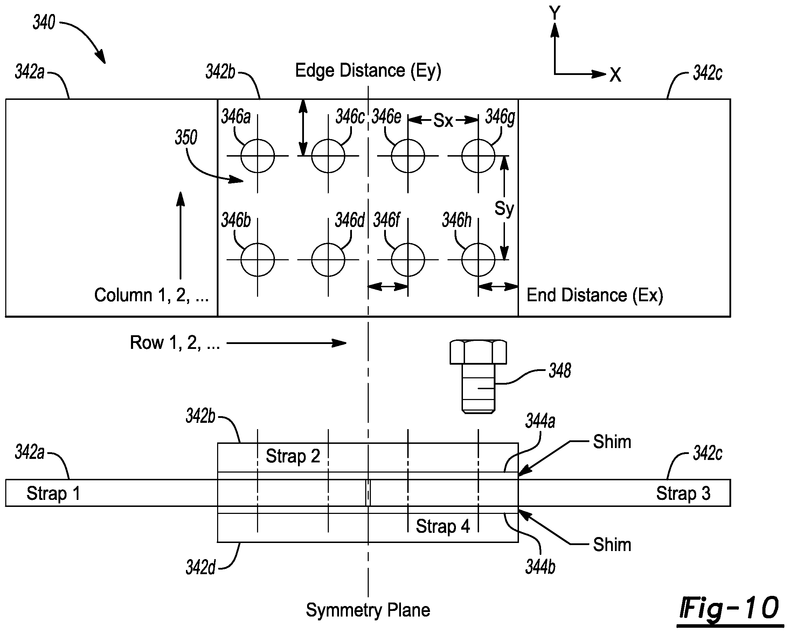

Referring to FIG. 10, a schematic plan and cross-sectional view diagram of an example joint 340 is shown in accordance with one or more exemplary examples. The joint 340 in the example includes multiple (e.g., four) straps 342a-342d, multiple (e.g., two) shims 344a-344b, and multiple (e.g., eight) fastener bores 346a-346h. Multiple fasteners (one shown) 348 are disposed in the fastener bores 346a-346h. The fastener bores 346a-346h and the respective fasteners 348 are arranged in a pattern 350.

Each strap 342a-342d is defined by a material, a thickness, a length, and a width. Likewise, each shim 344a-344b is defined by a material, a thickness, a length, and a width. The fastener bores 346a-346h are defined by a material a diameter, a length, and a width. The pattern 350 defines the number of columns (NC) (e.g., no greater than 4 in the example), a number of rows (NR) (e.g., no greater than 4 in the example), an x-spacing (Sx), and a y-spacing (Sy). Boundaries are defined by an edge distance (Ey) and an end spacing (Ex).

Examples of the disclosure are directed to a suite of Python scripts that enable automated modeling of common bolted joints for analyzing detailed stresses around fastener bores. The system/method is implemented as a plug-in to Abaqus/CAE, that is a commercial software suite for finite element analysis based simulations. The system/method is designed to handle manufacturing variations such as oversized bores and fasteners and out-of-spec preloads via parametric modeling. The system/method also has built-in material and fastener libraries. Therefore, time and effort in modeling and analysis is reduced and accuracy of stress predictions and strain predictions for both static and fatigue strength of fracture-sensitive joints is improved. The time and effort reductions result in cost savings in reducing model building and analysis time from days to hours for each detailed model. Furthermore, accurate predictions provided by the system/method avoid surprises from unexpected cracking that may lead to re-design, retooling, and/or delay certification and production.

Various examples of the system/method may: (1) be fully parametric and automated; (2) include commonly used bolted joint configurations: Single Shear, Double Shear, Generic bearing bypass, and tapered joint; (3) include up to M by M (e.g., 4 by 4) fasteners array with various pitch and spacing; (4) provide built-in libraries for fasteners and materials; (5) be able to assign variations to individual fasteners and bores; (6) include integrated analysis job submission to remote compute clusters; and (7) be capable of fiber-oriented meshing for advanced composite progressive failure analysis.

As explained above and reiterated below, the present disclosure includes, without limitation, the following example implementations.

Clause 1. A method for modeling joints with fasteners, comprising receiving a plurality of input parameters of a plurality of components connectable with one or more fasteners; calculating a plurality of second level parameters with a computer based on the plurality of input parameters; building a plurality of component models of the plurality of components absent the one or more fasteners based on the plurality of second level parameters; subtracting a plurality of fastener bores from the plurality of component models; generating an assembly model by combining the plurality of component models with one or more fastener models of the one or more fasteners in the plurality of fastener bores; applying a plurality of boundary conditions to the assembly model; applying a plurality of loads to the assembly model under the plurality of boundary conditions to generate a plurality of analysis key words; and generating an input file based on the plurality of analysis key words, wherein the input file is suitable for a finite element analysis.

Clause 2. The method according to clause 1, further comprising rotating a plurality of component nodes of the plurality of component models to align with a fiber orientation of the plurality of components.

Clause 3. The method according to clause 1, further comprising calculating a center of a curvature of the assembly model.

Clause 4. The method according to clause 3, further comprising updating a plurality of component nodes of the plurality of component models based on the center and the curvature of the assembly model.

Clause 5. The method according to clause 1, further comprising assigning a material to the plurality of component models.

Clause 6. The method according to clause 1, further comprising adding one or more extra models to the assembly model, wherein the one or more extra models include one or more strap models, spacer models, shim models, or a combination thereof.

Clause 7. The method according to clause 6, further comprising translating the one or more extra models within the assembly model.

Clause 8. The method according to clause 6, further comprising rotating the one or more extra models within the assembly model.

Clause 9. The method according to clause 1, further comprising reading the plurality of input parameters and the one or more fasteners from one or more libraries.

Clause 10. A system for modeling joints with fasteners, comprising one or more libraries operational to store a plurality of input parameters of a plurality of components and a plurality of fasteners; and a computer operational to: receive the plurality of input parameters of the plurality of components connectable with one or more fasteners from the one or more libraries; calculate a plurality of second level parameters based on the plurality of input parameters; build a plurality of component models of the plurality of components absent the one or more fasteners based on the plurality of second level parameters; subtract a plurality of fastener bores from the plurality of component models; generate an assembly model by combining the plurality of component models with one or more fastener models of the one or more fasteners in the plurality of fastener bores; apply a plurality of boundary conditions to the assembly model; apply a plurality of loads to the assembly model under the plurality of boundary conditions to generate a plurality of analysis key words; and generate an input file based on the plurality of analysis key words, wherein the input file is suitable for a finite element analysis.

Clause 11. The system according to clause 10, wherein the computer is further operational to: rotate a plurality of component nodes of the plurality of component models to align with a fiber orientation of the plurality of components.

Clause 12. The system according to clause 10, wherein the computer is further operational to calculate a center of a curvature of the assembly model.

Clause 13. The system according to clause 12, wherein the computer is further operational to update a plurality of component nodes of the plurality of component models based on the center and the curvature of the assembly model.

Clause 14. The system according to clause 10, wherein the computer is further operational to assign a material to the plurality of component models.

Clause 15. The system according to clause 10, wherein the computer is further operational to add one or more extra models to the assembly model, wherein the one or more extra models include one or more strap models, spacer models, shim models, or a combination thereof.

Clause 16. The system according to clause 15, wherein the computer is further operational to translate the one or more extra models within the assembly model.

Clause 17. The system according to clause 15, wherein the computer is further operational to rotate the one or more extra models within the assembly model.

Clause 18. A non-transitory computer readable storage medium storing instructions that control data processing, the instructions, when executed by a processor cause the processor to perform a plurality of operations comprising receiving a plurality of input parameters of a plurality of components connectable with one or more fasteners; calculating a plurality of second level parameters based on the plurality of input parameters; building a plurality of component models of the plurality of components absent the one or more fasteners based on the plurality of second level parameters; subtracting a plurality of fastener bores from the plurality of component models; generating an assembly model by combining the plurality of component models with one or more fastener models of the one or more fasteners in the plurality of fastener bores; applying a plurality of boundary conditions to the assembly model; applying a plurality of loads to the assembly model under the plurality of boundary conditions to generate a plurality of analysis key words; and generating an input file based on the plurality of analysis key words, wherein the input file is suitable for a finite element analysis.

Clause 19. The non-transitory computer readable storage medium according to clause 18, wherein the plurality of operations further comprises rotating a plurality of component nodes of the plurality of component models to align with a fiber orientation of the plurality of components.

Clause 20. The non-transitory computer readable storage medium according to clause 18, wherein the plurality of operations further comprises calculating a center of a curvature of the assembly model; and updating a plurality of component nodes of the plurality of component models based on the center and the curvature of the assembly model.

This disclosure is susceptible of examples in many different forms. Representative examples of the disclosure are shown in the drawings and are herein described in detail with the understanding that these examples are provided as an exemplification of the disclosed principles, not limitations of the broad aspects of the disclosure. To that extent, elements and limitations that are described, for example, in the Abstract, Background, Summary, and Detailed Description sections, but not explicitly set forth in the claims, should not be incorporated into the claims, singly or collectively, by implication, inference or otherwise.

For purposes of the present detailed description, unless specifically disclaimed, the singular includes the plural and vice versa. The words "and" and "or" shall be both conjunctive and disjunctive. The words "any" and "all" shall both mean "any and all", and the words "including," "containing," "comprising," "having," and the like shall each mean "including without limitation." Moreover, words of approximation such as "about," "almost," "substantially," "approximately," and "generally," may be used herein in the sense of "at, near, or nearly at," or "within 0-5% of," or "within acceptable manufacturing tolerances," or other logical combinations thereof. Referring to the drawings, wherein like reference numbers refer to like components.
1. A method for modeling joints with fasteners, comprising: receiving a plurality of input
   parameters of a plurality of components connectable with one or more fasteners; calculating a plurality of second level parameters with a computer based on the plurality of input parameters; building a plurality of component models of the plurality of components absent the one or more fasteners based on the plurality of second level parameters; subtracting a plurality of fastener bores from the plurality of component model; generating an assembly model by combining the plurality of component models with one or more fastener models of the one or more fasteners in the plurality of fastener bores; applying a plurality of boundary conditions to the assembly model; applying a plurality of loads to the assembly model under the plurality of boundary conditions to generate a plurality of analysis key words; and generating an input file based on the plurality of analysis key words, wherein the input file is suitable for a finite element analysis.
2. The method according to clause 1, further comprising: rotating a plurality of component nodes of the plurality of component models to align with a fiber orientation of the plurality of components.
3. The method according to clause 1 or 2, further comprising: calculating a center of a curvature of the assembly model.
4. The method according to clause 3, further comprising: updating a plurality of component nodes of the plurality of component models based on the center and the curvature of the assembly model.
5. The method according to any one of the preceding clauses, further comprising: assigning a material to the plurality of component models.
6. The method according to any one of the preceding clauses, further comprising:
   adding one or more extra models to the assembly model, wherein the one or more extra models include one or more strap models, spacer models, shim models, or a combination thereof.
7. The method according to clause 6, further comprising:
   translating the one or more extra models within the assembly model.
8. The method according to claim 6, further comprising: rotating the one or more extra models within the assembly model.
9. The method according to any one of the preceding claims, further comprising: reading the plurality of input parameters and the one or more fasteners from one or more libraries.
10. A system for modeling joints with fasteners, comprising: one or more libraries operational to store a plurality of input parameters of a plurality of components and a plurality of fasteners; and a computer operational to: receive the plurality of input parameters of the plurality of components connectable with one or more fasteners from the one or more libraries; calculate a plurality of second level parameters based on the plurality of input parameters;
   build a plurality of component models of the plurality of components absent the one or more fasteners based on the plurality of second level parameters; subtract a plurality of fastener bores from the plurality of component models; generate an assembly model by combining the plurality of component models with one or more fastener models of the one or more fasteners in the plurality of fastener bores; apply a plurality of boundary conditions to the assembly model; apply a plurality of loads to the assembly model under the plurality of boundary conditions to generate a plurality of analysis key words; and generate an input file based on the plurality of analysis key words, wherein the input file is suitable for a finite element analysis.
11. The system according to clause 10, wherein the computer is further operational to:
   rotate a plurality of component nodes of the plurality of component models to align with a fiber orientation of the plurality of components.
12. The system according to clause 10 or 11, wherein the computer is further operational to: calculate a center of a curvature of the assembly model.
13. The system according to clause 12, wherein the computer is further operational to:
   update a plurality of component nodes of the plurality of component models based on the center and the curvature of the assembly model.
14. The system according to any one clauses 10-13, wherein the computer is further operational to:
   assign a material to the plurality of component models.
15. The system according to any one of clauses 10-14, wherein the computer is further operational to:
   add one or more extra models to the assembly model, wherein the one or more extra models include one or more strap models, spacer models, shim models, or a combination thereof.
16. The system according to clause 15, wherein the computer is further operational to:
   translate the one or more extra models within the assembly model.
17. The system according to clause 15 or 16, wherein the computer is further operational to: rotate the one or more extra models within the assembly model.
18. A computer readable storage medium storing instructions that control data processing, the instructions, when executed by a processor cause the processor to perform a plurality of operations comprising:
   receiving a plurality of input parameters of a plurality of components connectable with one or more fasteners;
   calculating a plurality of second level parameters based on the plurality of input parameters;
   building a plurality of component models of the plurality of components absent the one or more fasteners based on the plurality of second level parameters;
   subtracting a plurality of fastener bores from the plurality of component models;
   generating an assembly model by combining the plurality of component models with one or more fastener models of the one or more fasteners in the plurality of fastener bores;
   applying a plurality of boundary conditions to the assembly model;
   applying a plurality of loads to the assembly model under the plurality of boundary conditions to generate a plurality of analysis key words; and
   generating an input file based on the plurality of analysis key words, wherein the input file is suitable for a finite element analysis.
19. The non-transitory computer readable storage medium according to clause 18, wherein the plurality of operations further comprises: rotating a plurality of component nodes of the plurality of component models to align with a fiber orientation of the plurality of components.
20. The non-transitory computer readable storage medium according to clause 18 or 19, wherein the plurality of operations further comprises: calculating a center of a curvature of the assembly model; and updating a plurality of component nodes of the plurality of component models based on the center and the curvature of the assembly model.

The detailed description and the drawings or FIGS. are supportive and descriptive of the disclosure, but the scope of the disclosure is defined solely by the clauses. While some of the best modes and other examples for carrying out the claimed disclosure have been described in detail, various alternative designs and examples exist for practicing the disclosure defined in the appended claims. Furthermore, the examples shown in the drawings or the characteristics of various examples mentioned in the present description are not necessarily to be understood as examples independent of each other. Rather, it is possible that each of the characteristics described in one of the examples of an example may be combined with one or a plurality of other desired characteristics from other examples, resulting in other examples not described in words or by reference to the drawings. Accordingly, such other examples fall within the framework of the scope of the appended claims.

## Claims

1. A method (100) for modeling joints (340) with fasteners (348), comprising:
Receiving (119) a plurality of input parameters (115) of a plurality of components (342a-342d) connectable with one or more fasteners (348);
calculating (120) a plurality of second level parameters (121) with a computer (310) based on the plurality of input parameters (115);
building (124) a plurality of component models (125a) of the plurality of components (342a-342d) absent the one or more fasteners (348) based on the plurality of second level parameters (121);
subtracting (188) a plurality of fastener bores (346a-346h) from the plurality of component models (125a);
generating an assembly model (125h) by combining the plurality of component models (125a) with one or more fastener models (125c) of the one or more fasteners (348) in the plurality of fastener bores (346a-346h);
applying (138) a plurality of boundary conditions (139) to the assembly model (125h);
applying (140) a plurality of loads (141) to the assembly model (125h) under the plurality of boundary conditions (139) to generate a plurality of analysis key words (143); and
generating (142) an input file (145) based on the plurality of analysis key words (143), wherein the input file (145) is suitable for a finite element analysis.

2. The method (100) according to claim 1, further comprising:
calculating (224) a center of a curvature (225) of the assembly model (125h); and optionally further comprising:
updating (132) a plurality of component nodes (129) of the plurality of component models (125a) based on the center and the curvature (225) of the assembly model (125h).

3. The method (100) according to claim 1, further comprising:
assigning (270) a material (271) to the plurality of component models (125a); or optionally further comprising:
reading (112) the plurality of input parameters (115) and the one or more fasteners (348) from one or more libraries (106a-106b); or optionally further comprising:
rotating (204) a plurality of component nodes (129) of the plurality of component models (125a) to align with a fiber orientation (203) of the plurality of components (342a-342d).

4. The method (100) according to claim 1, further comprising:
adding (244-252) one or more extra models (125d) to the assembly model (125h), wherein the one or more extra models (125d) include one or more strap models (125e), spacer models (125f) , shim models (125g), or a combination thereof.

5. The method (100) according to claim 4, further comprising:
translating (244-252) the one or more extra models (125d) within the assembly model (125h); or optionally further comprising:
rotating (244-252) the one or more extra models (125d) within the assembly model (125h).

6. A system (300) for modeling joints (340) with fasteners (348), comprising:
One or more libraries (106a-106b) operational to store a plurality of input parameters (115) of a plurality of components (342a-342d) and a plurality of fasteners (348); and
a computer (310) operational to:
receive the plurality of input parameters (115) of the plurality of components (342a-342d) connectable with one or more fasteners (348) from the one or more libraries (106a-106b);
calculate a plurality of second level parameters (121) based on the plurality of input parameters (115);
build a plurality of component models (125a) of the plurality of components (342a-342d) absent the one or more fasteners (348) based on the plurality of second level parameters (121);
subtract a plurality of fastener bores (346a-346h) from the plurality of component models (125a);
generate an assembly model (125h) by combining the plurality of component models (125a) with one or more fastener models (125c) of the one or more fasteners (348) in the plurality of fastener bores (346a-346h);
apply a plurality of boundary conditions (139) to the assembly model (125h);
apply a plurality of loads (141) to the assembly model (125h) under the plurality of boundary conditions (139) to generate a plurality of analysis key words (143); and
generate an input file (145) based on the plurality of analysis key words (143), wherein the input file (145) is suitable for a finite element analysis.

7. The system (300) according to claim 6, wherein the computer (310) is further operational to:
rotate a plurality of component nodes (129) of the plurality of component models (125a) to align with a fiber orientation (203) of the plurality of components (342a-342d).

8. The system (300) according to claim 6, wherein the computer (310) is further operational to:
calculate a center of a curvature (225) of the assembly model (125h).

9. The system (300) according to claim 8, wherein the computer (310) is further operational to:
update a plurality of component nodes (129) of the plurality of component models (125a) based on the center and the curvature (225) of the assembly model (125h).

10. The system (300) according to claim 6, wherein the computer (310) is further operational to:
assign a material (271) to the plurality of component models (125a).

11. The system (300) according to claim 6, wherein the computer (310) is further operational to:
add (244-252) one or more extra models (125d) to the assembly model (125h), wherein the one or more extra models (125d) include one or more strap models (125e), spacer models (125f), shim models (125g), or a combination thereof.

12. The system (300) according to claim 11, wherein the computer (310) is further operational to:
translate the one or more extra models (125d) within the assembly model (125h).

13. The system (300) according to claim 11, wherein the computer (310) is further operational to:
rotate the one or more extra models (125d) within the assembly model (125h).

14. A computer readable storage medium (314a) storing instructions (316) that control data processing, the instructions (316), when executed by a processor (312) cause the processor (312) to perform a plurality of operations comprising:
Receiving (119) a plurality of input parameters (115) of a plurality of components (342a-342d) connectable with one or more fasteners (348);
calculating (120) a plurality of second level parameters (121) based on the plurality of input parameters (115);
building (124) a plurality of component models (125a) of the plurality of components (342a-342d) absent the one or more fasteners (348) based on the plurality of second level parameters (121);
subtracting (188) a plurality of fastener bores (346a-346h) from the plurality of component models (125a);
generating an assembly model (125h) by combining the plurality of component models (125a) with one or more fastener models (125c) of the one or more fasteners (348) in the plurality of fastener bores (346a-346h);
applying (138) a plurality of boundary conditions (139) to the assembly model (125h);
applying (140) a plurality of loads (141) to the assembly model (125h) under the plurality of boundary conditions (139) to generate a plurality of analysis key words (143); and
generating an input file (145) based on the plurality of analysis key words (143), wherein the input file (145) is suitable for a finite element analysis.

15. The computer readable storage medium (314a) according to claim 14, wherein the plurality of operations further comprises:
rotating (204) a plurality of component nodes (129) of the plurality of component models (125a) to align with a fiber orientation (203) of the plurality of components (342a-342d); or optionally
wherein the plurality of operations further comprises:
calculating (224) a center of a curvature (225) of the assembly model (125h); and
updating (132) a plurality of component nodes (129) of the plurality of component models (125a) based on the center and the curvature (225) of the assembly model (125h).
